# EUROPÄISCHE PATENTANMELDUNG

(11) **EP 1 275 994 A1**
(43) Veröffentlichungstag der Anmeldung: **15.01.2003**
(21) Anmeldenummer: 02011390.8
(22) Anmeldetag: 23.05.2002
(51) Int. Cl.: G02B 6/43, H05K 5/02

(54) **Gehäuse für elektrische Baugruppen**

(30) Priorität: 27.06.2001 DE 10130892
(71) Anmelder: SIEMENS AKTIENGESELLSCHAFT, 80333 München (DE)
(72) Erfinder: Niggl, Heinz-Juergen, 82343 Pöcking (DE)
(74) Vertreter: Berg, Peter, Dipl.-Ing.

(57) **Zusammenfassung**

Die Erfindung betrifft ein Gehäuse (10) für elektrische und/oder elektronische Baugruppen (14') mit Gehäuseverkleidungsteilen (11), wobei das Gehäuse (10) an jeweils einander angrenzenden Gehäuseverkleidungsteilen (11) Fugen (13, 13') aufweist. Erfindungsgemäß ist vorgesehen, dass die Fugen (13, 13') zwischen jeweils aneinander angrenzenden Gehäuseverkleidungsteilen (11) derart bemessen sind, dass dort Mittel (18, 18', 18'') zum Darstellen gehäuse- oder baugruppenspezifischer Funktionen positionierbar sind. Im Ausführungsbeispiel umfassen die Mittel zumindest ein Lichtleiterelement (18), wobei das Lichtleiterelement (18) mit seinem ausgangsseitigen Ende (18'') in einer Fuge (13') angeordnet und mit seinem eingangsseitigen Ende (18') an wenigstens eine mit zumindest einer in dem Gehäuse aufgenommene Baugruppe (14') korrespondierenden optischen Signalgebereinrichtung (16) angekoppelt ist.

## Beschreibung

Die Erfindung betrifft ein Gehäuse für elektrische und/oder elektronische Baugruppen mit Gehäuseverkleidungsteilen, wobei das Gehäuse an jeweils einander angrenzenden Gehäuseverkleidungsteilen Fugen aufweist.

Bei derartigen Gehäusen weisen die Gehäuseverkleidungsteile insbesondere in dem als Gehäusestirnseite ausgebildeten Gehäuseverkleidungsteil Durchbrüche oder Lochungen zur Aufnahme von Funktionselementen, wie beispielsweise Anzeigeelemente oder Bedienelemente, auf. Unbefriedigend bei diesem Stand der Technik ist jedoch, dass je nach Spezifikation eine jeweils unterschiedliche Zahl oder Anordnung von Durchbrüchen oder Lochungen erforderlich ist, so dass eine beträchtliche Typenvielfalt von Gehäuseverkleidungsteilen gefertigt und auf Lager gehalten werden muss.

Es besteht daher die Aufgabe, ein Gehäuse bereitzustellen, bei dem den jeweiligen Anforderungen entsprechende Öffnungen vorgesehen sind und gleichwohl die Anzahl unterschiedlicher Typen von Gehäuseverkleidungsteilen möglichst gering ist.

Gelöst ist diese Aufgabe dadurch, dass die Fugen zwischen jeweils aneinander angrenzenden Gehäuseverkleidungsteilen derart bemessen sind, dass dort Mittel zum Darstellen gehäuse- oder baugruppenspezifischer Funktionen positionierbar sind.

Im Unterschied zum Stand der Technik, bei dem die benachbarten Gehäuseverkleidungsteile in den Fugen derart dicht aufeinanderstoßen, dass praktisch kein Zwischenraum bleibt, ist für die Erfindung mithin charakteristisch, dass der jeweilige Abstand zwischen jeweils aneinander angrenzenden Gehäuseverkleidungsteilen ausreichend groß bemessen ist, um dort Funktionselemente aufzunehmen. Indem die durch die Fugen definierten Zwischenräume im Gehäuse den jeweiligen Anforderungen entsprechend dimensionierbar sind, lassen sich somit die Gehäuseverkleidungsteile standardisiert ausbilden, so dass sich die Zahl unterschiedlicher Typen von Gehäuseverkleidungsteilen deutlich reduziert.

Eine Ausgestaltung der Erfindung, mit der beispielsweise optische Informationssignale von auf einer Baugruppe vorgesehenen optischen Signalgebereinrichtungen erfassbar und nach außen transmittierbar sind, sieht vor, dass die Mittel zumindest einen Lichtleiter umfassen, wobei der Lichtleiter ausgangsseitig in einer Fuge angeordnet und eingangsseitig an wenigstens eine mit zumindest einer in dem Gehäuse aufgenommene Baugruppe korrespondierenden Signalgebereinrichtung angekoppelt ist. Im Falle einer Vielzahl von der Baugruppe zugehörigen Signalgebereinrichtungen ist es vorteilhaft, wenn mehrere Lichtleiterelemente vorgesehen sind, deren ausgangsseitige Enden sequentiell entlang der Längserstreckungsrichtung der jeweils zugeordneten Fuge angeordnet sind, wobei der Abstand zwischen jeweils unmittelbar benachbarten ausgangsseitigen Enden der Lichtleiterelemente etwa konstant ist und sich die sequentiell angeordneten ausgangsseitigen Enden der Lichtleiterelemente etwa über die Erstreckungslänge der jeweils zugeordneten Fuge erstrecken. Dadurch ergibt sich ein einheitliches Rastermaß für die ausgangsseitigen Enden der Lichtleiterelemente und zudem eine günstige und übersichtliche Raumausnutzung der zugeordneten Fuge.

Besonders übersichtlich sind die Lichtleiterelemente innerhalb des Gehäuses angeordnet, wenn die den ausgangsseitigen Enden zugeordneten eingangsseitigen Enden der Lichtleiterelemente entlang einer etwa parallel zur Erstreckungslänge der Fuge verlaufenden Erstreckungsrichtung der Baugruppe angeordnet sind. Besonders zweckmäßig ist dabei, wenn die Lichtleiterelemente derart positioniert sind, dass das jeweils eingangsseitige Ende und das zugeordnete ausgangsseitige Ende des jeweiligen Lichtleiterelements auf jeweils etwa gleicher Ortskoordinate bezüglich der Längserstreckungsrichtung der zugeordneten Fuge liegen. Es ergibt sich dadurch für die eingangsseitigen Enden das gleiche Rastermaß wie für jeweils zugeordneten ausgangsseitigen Enden und zudem wird bei gegebenenfalls erforderlichen Justagearbeiten im Innenraum des Gehäuses eine visuelle Zuordnung der einzelnen Lichtleiterelemente erleichtert.

Anhand der beigefügten Zeichnung soll nachstehend eine Ausführungsform des erfindungsgemäßen Gehäuses näher erläutert werden. In stark schematischen Ansichten zeigen:
Fig. 1 eine im Schnitt gehaltene Draufsicht auf das erfindungsgemäße Gehäuse mit einer darin aufgenommenen Baugruppe, wobei auf der Bestückungsseite der Baugruppe eine Leuchtdiode angeordnet und ein Lichtleiterelement mit seinem eingangsseitigen Ende der Leuchtdiode zugewandt ist, dessen ausgangsseitiges Ende in einer Fuge des Gehäuses positioniert ist, und
Fig. 2 eine teilweise geschnittene Seitenansicht des erfindungsgemäßen Gehäuses mit in der Fuge des Gehäuses positionierten Lichtleiterelementen.

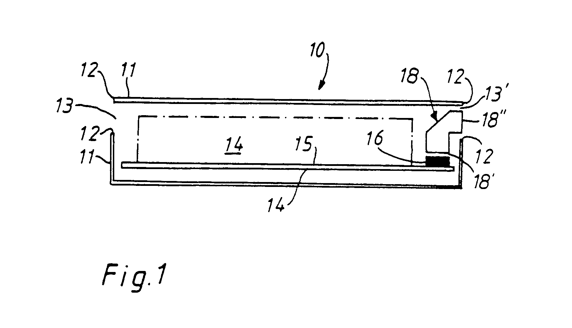

Fig. 1 zeigt ein im ganzen mit 10 bezeichnetes Gehäuse, das durch Gehäuseverkleidungsteile 11 nach außen abgeschlossen ist, wobei an aneinander angrenzenden Kanten 12 von jeweils unmittelbar benachbarten Gehäuseverkleidungsteilen 11 zwischengeordnete Fugen 13, 13' vorgesehen sind. In dem Gehäuse 10 ist eine auf einer Leiterplatte 14 angeordnete elektronische Baugruppe 14' aufgenommen, wobei die Bestückungsseite 15 der Baugruppe 14' bzw. Leiterplatte 14 den gegenüberliegenden Fugen 13, 13' zugewandt ist. Eine im Ausführungsbeispiel auf der Bestückungsseite 15 der Leiterplatte 14 angeordnete Leuchtdiode 16, die beispielsweise als SMD-(Surface Mounted Device)-Leuchtdiode ausgebildet sein kann und angrenzend zu einer Seitenkante 17 der Leiterplatte 14 angeordnet ist, dient zur optischen Anzeige von Informationssignalen, welche einer baugruppenspezifischen Funktion zugeordnet sind.

Ein Bündel von Lichtleiterelementen 18 ist so im Innenraum des Gehäuses 10 angeordnet, dass die eingangsseitigen Enden 18' der Lichtleiterelemente 18 der Bestückungsseite 15 der Leiterplatte 14 zugewandt im Bereich einer Seitenkante 17 angeordnet sind und die ausgangsseitigen Enden 18'' der Lichtleiterelemente 18 in der der Seitenkante 17 der Leiterplatte 14 zugewandten Fuge 13' positioniert sind, so dass die Lichtleiterelemente 18 zwischen ihren beiden Enden 18, 18' entsprechend gekrümmt sind. Ein Lichtleiterelement 18 ist der in Fig. 1 dargestellten SMD-Leuchtdiode 16 zugeordnet, indem das eingangsseitige Ende 18' des Lichtleiterelements 18 der SMD-Leuchtdiode 16 zugewandt ist, wobei lediglich ein geringer Luftspalt zwischen dem eingangsseitigen Ende 18' des Lichtleitelements 18 und der SMD-Leuchtdiode 16 vorgesehen ist, um eine möglichst hohe Lichtintensität aus der SMD-Leuchtdiode 16 in das zugeordnete Lichtleiterelement 18 einzukoppeln.

Bei durchgeschaltetem Zustand der SMD-Leuchtdiode 16, der mit dem Vorliegen eines vorbestimmten Wertes einer baugruppenspezifischen Funktion verknüpft sein kann, ist die damit einhergehende Emission von Lichtquanten von dem zugeordneten eingangsseitigen Ende 18' des Lichtleiterelements 18 erfassbar und wird auf das ausgangsseitige Ende 18'' des Lichtleiterelements 18 abgebildet. Da das ausgangsseitige Ende 18'' des Lichtleiterelements 18 bündig mit den Begrenzungskanten 12 der zugeordneten Fuge 13' abschließt, ist dort das entsprechende optische Signal beim Austritt aus dem ausgangsseitigen Ende 18'' des Lichtleitelements 18 erkennbar.

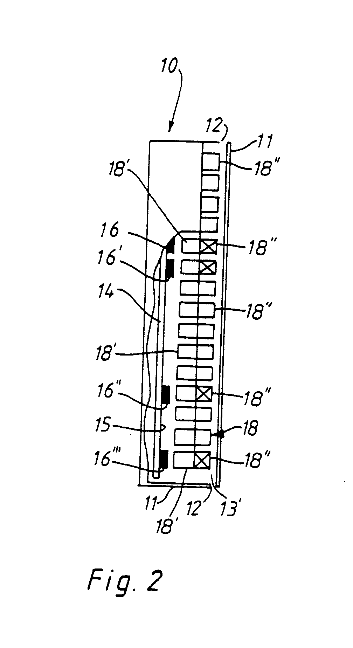

Aus Fig. 2 ist ersichtlich, wie der jeweilige Schaltzustand von weiteren auf der Bestückungsseite 15 der Leiterplatte 14 angeordneten Leuchtdioden 16', 16'', 16''' in der zugeordneten Fuge 13', die sich im Ausführungsbeispiel vertikal erstreckt, darstellbar ist. Dazu sind die ausgangsseitigen Enden 18'' von weiteren Lichtleiterelementen 18 sequentiell in der zugeordneten Fuge 13' entlang deren Längserstreckungsrichtung mit etwa konstantem Abstand voneinander angeordnet, während die eingangsseitigen Enden 18' der Lichtleiterelemente der Bestückungsseite 15 der Leiterplatte 14 zugewandt sind und dort ebenfalls sequentiell entlang der Erstreckungsrichtung der Seitenkante 17 der Leiterplatte 14 mit gleichem Abstand voneinander wie die zugeordneten ausgangsseitigen Enden 18'' verlaufen. Dadurch sind die weiteren Leuchtdioden 16', 16'' sowie 16''', die fluchtend zur SMD-Leuchtdiode 16 in Erstreckungsrichtung der Seitenkante 17 der Leiterplatte 14 angeordnet sind, durch die ihnen jeweils gegenüberstehenden ausgangsseitigen Enden 18'' der Lichtleiterelemente abbildungstechnisch erfassbar, so dass den jeweiligen Leuchtdioden 16, 16', 16'', 16''' zugeordnete optische Signale auf die jeweiligen ausgangsseitigen Enden 18'' der Lichtleiterelemente abbildbar sind. Die Zuordnung eines bestimmten optischen Informationssignals bzw. einer bestimmten Leuchtdiode zum jeweiligen Lichtleiterelement ist besonders übersichtlich, da jedes der Lichtleiterelemente so positioniert ist, dass das eingangsseitige 18' und das ausgangsseitige Ende 18'' die gleiche Ortskoordinate in Längserstreckungsrichtung der zugeordnete Fuge 13' aufweisen und sich lediglich bezüglich der Ortskoordinaten in den dazu orthogonalen Richtungen unterscheiden.

Innerhalb der jeweiligen Fuge 13, 13' lassen sich zusätzlich zu den ausgangsseitigen Enden 18'' der Lichtleiterelemente 18 gegebenenfalls Lüftungsöffnungen, Kabelausführungen oder entsprechende Beschriftungen für die jeweiligen Lichtieiterelemente 18 vorsehen.

### Bezugszeichenliste

- 10: Gehäuse
- 11: Gehäuseverkleidungsteil
- 12: Kanten
- 13: Fuge
- 13': Fuge
- 14: Leiterplatte
- 14': Baugruppe
- 15: Bestückungsseite
- 16: SMD-Leuchtdiode
- 16': Leuchtdiode
- 16'': Leuchtdiode
- 16''': Leuchtdiode
- 17: Seitenkante der Leiterplatte
- 18: Lichtleiterelement
- 18': eingangsseitiges Ende
- 18'': ausgangsseitiges Ende

## Patentansprüche

1. Gehäuse für elektrische und/oder elektronische Baugruppen mit Gehäuseverkleidungsteilen, wobei das Gehäuse an jeweils einander angrenzenden Gehäuseverkleidungsteilen Fugen aufweist,
**dadurch gekennzeichnet,**
**dass** die Fugen (13, 13') zwischen jeweils aneinander angrenzenden Gehäuseverkleidungsteilen (11) derart bemessen sind, dass dort Mittel (18, 18', 18'') zum Darstellen gehäuse- oder baugruppenspezifischer Funktionen positionierbar sind.

2. Gehäuse nach Anspruch 1, **dadurch gekennzeichnet, dass** die Mittel zumindest ein Lichtleiterelement (18) umfassen, wobei das Lichtleiterelement (18) ausgangsseitig in einer Fuge (13') angeordnet und eingangsseitig an wenigstens eine mit zumindest einer in dem Gehäuse aufgenommene Baugruppe (14') korrespondierenden Signalgebereinrichtung (16) angekoppelt ist.

3. Gehäuse nach Anspruch 2, **dadurch gekennzeichnet, dass** mehrere Lichtleiterelemente (18) vorgesehen sind, deren ausgangsseitige Enden (18'') sequentiell entlang der Längserstreckungsrichtung der jeweils zugeordneten Fuge (13') angeordnet sind.

4. Vorrichtung nach Anspruch 3, **dadurch gekennzeichnet, dass** der Abstand zwischen jeweils unmittelbar benachbarten ausgangsseitigen Enden (18'') der Lichtleiterelemente (18) etwa konstant ist.

5. Vorrichtung nach Anspruch 3 oder 4, **dadurch gekennzeichnet, dass** sich die sequentiell angeordneten ausgangsseitigen Enden (18'') der Lichtleiterelemente (18) etwa über die Erstreckungslänge der jeweils zugeordneten Fuge (13') erstrecken.

6. Gehäuse nach Anspruch 5, **dadurch gekennzeichnet, dass** die den ausgangsseitigen Enden (18'') zugeordneten eingangsseitigen Enden (18') der Lichtleiterelemente (18) entlang einer etwa parallel zur Erstreckungslänge der Fuge (13') verlaufenden Erstreckungsrichtung der Baugruppe (14') angeordnet sind.

7. Gehäuse nach Anspruch 6, **dadurch gekennzeichnet, dass** die Lichtleiterelemente (18) derart positioniert sind, dass das jeweilige eingangsseitige Ende (18') und das zugeordnete ausgangsseitige Ende (18'') des jeweiligen Lichtleiterelements (18) auf jeweils etwa gleicher Ortskoordinate bezüglich der Längserstreckungsrichtung der zugeordneten Fuge (13') liegen.
